# EUROPEAN PATENT SPECIFICATION

(11) **EP 1 155 437 B1**
(45) Date of publication and mention of the grant of the patent: **20.08.2008**
(21) Application number: 00906209.2
(22) Date of filing: 19.01.2000
(51) Int. Cl.: H01L 21/00

(54) **COOLED SHOWERHEAD FOR RAPID THERMAL PROCESSING (RTP) SYSTEM**
GEKÜHLTER BRAUSEKOPF FÜR EINE SCHNELLE WÄRMEBEHANDLUNGSANLAGE
TETE DE DOUCHE REFROIDIE POUR SYSTEME DE TRAITEMENT THERMIQUE RAPIDE (RTP)

(30) Priority: 04.02.1999 US 245139
(43) Date of publication of application: 21.11.2001
(73) Proprietor: STEAG RTP Systems GmbH, 89160 Dornstadt (DE)
(72) Inventor: THEILER, Thomas, D-89075 Ulm (DE); FALTER, Manfred, D-89077 Ulm (DE); WALK, Heinrich, D-89604 Allmendigen (DE)
(74) Representative: Wagner, Karl H.
(86) International application number: PCT/EP2000/000379
(87) International publication number: WO 2000/046840

(56) References cited:
- EP-A- 0 374 511
- EP-A- 0 847 077
- US-A- 5 156 820
- US-A- 5 240 556
- US-A- 5 863 843
- US-A- 5 892 886

## Description

### FIELD OF THE INVENTION

The field of the invention is the field of rapid thermal processing (RTP) of objects such as semiconductor wafers and components which must have temperatures changes rapidly and uniformly. In particular, the field of invention is the introduction of fluids into such RTP systems so that the fluids impinge on the surface of the object to be processed in a very uniform and controllable manner.

### BACKGROUND OF THE INVENTION

The field of rapid thermal processing (RTP) has dealt mainly with the uniformity of heating of the semiconductor wafers treated in the RTP systems. RTP systems generally have a chamber with at least one wall transparent to radiation from sources of radiation such as lamps. The object to be processed is placed in the chamber and irradiated with radiation from the radiation source so that the object is heated. The chamber with the transparent wall is not strictly necessary in the system, provided that the system controls the atmosphere in which the object is placed during processing. The lamps could then be placed in proximity to the object without the intervening window. Much progress has been made in using batteries of lamps with individual control of each lamp to increase uniformity of the illuminating radiation. The uniformity is now sufficient that very thin layers of oxide or nitride may be grown on a silicon wafer in a few seconds.
Such RTP systems may be used for chemical vapor deposition (CVD) or plasma enhanced CVD (PE-CVD) deposition. In prior art systems, the object to be processed, generally a semiconductor wafer, is held in the system by a succeptor which may be heated, and the heat transferred to the wafer. Reactive gases are introduced into the system from the opposite side of the wafer than the succeptor. Generally, the reactive gases are introduced from the sides of the wafer, if the side of the wafer away from the succeptor is irradiated by the radiation sources of the RTP system. Introduction of the reactive gases from the sides leads to non uniform densities of gas over the surface of the wafer, and non uniform films of deposited or reacted material result from such non uniform starting conditions.

Prior art systems have used a showerhead arrangement to impinge reactive gases on to the wafer with greater uniformity. These prior art systems have used reflective showerheads to reflect the infrared light from the wafer back to the wafer, which increases uniformity of temperature across the wafer. Such showerheads preclude the radiation of the wafer from the deposition side, however.
As RTP systems deal with larger and larger wafers (300 mm diameter at present), the relative dimensions of the RTP chambers are changing, and the ancillary pieces of the RTP system are approaching relatively closer to the wafer. There is a greater and greater problem with the heating of the ancillary pieces by the long wavelength infrared radiation from the hot wafer, and it becomes harder and harder to cool the chamber walls and anything which the long wavelength radiation reaches. In particular, a showerhead which is transparent to the visible and near infra red (IR) light from the RTP system radiation sources which would be necessary for uniform supply of reactive gases in a CVD or PE-CVD RTP systems irradiated from the deposition side. Such a showerhead would be heated by the long wavelength IR from the hot wafer, and the reactive gases would react on the hot surfaces of the showerhead. Build up of films of silicon, for example, on the showerhead would lead to a rapid runaway situation, where the silicon would absorb visible and near IR light and become even hotter and produce more reaction.

### RELATED PATENTS AND APPLICATIONS

Reactors based on the RTP principle often have the entire cross section of one end of the reactor chamber open during the wafer handling process. This construction has been established because the various wafer holders, guard rings, and gas distribution plates, which have significantly greater dimensions and may be thicker than the wafers, must also be introduced into the chamber and must be easily and quickly changed when the process is changed or when different wafer sizes, for example, are used. The reaction chamber dimensions are designed with these ancillary pieces in mind. US Patent 5,580,830 teaches the importance of the gas flow and the use of an aperture in the door to regulate gas flow and control impurities in the process chamber.

The importance of measuring the temperature of the wafer using a pyrometer of very broad spectral response is taught in U. S. Patent 5,628, 564.
The wafer to be heated in a conventional RTP system typically rests on a plurality of quartz pins which hold the wafer accurately parallel to the reflector walls of the system. Prior art systems have rested the wafer on an instrumented susceptor, typically a uniform silicon wafer. US Patent 5,861,609 teaches the importance of susceptor plates separated from the wafer.
Rapid thermal processing of III-IV semiconductors has not been as successful as RTP of silicon. One reason for this is that the surface has a relatively high vapor pressure of, for example, arsenic (As) in the case of gallium arsenide (GaAs). The surface region becomes depleted of As, and the material quality suffers. US Patent 5,837,555 supplies a method and apparatus for overcoming this problem.
A method of raising the emissivity of a lightly doped, relatively low temperature wafer by locally heating the wafer with a pulse of light is disclosed in US Patent 5,727,017.
A method, apparatus, and system for RTP an object is disclosed in US Patent 5,935,650 filed Oct. 17, 1997, by Lerch et al.
A method of RTP of a substrate where a small amount of a reactive gas is used to control the etching of oxides or semiconductor is disclosed in US Patent 6,100,149, by Nenyei et al, filed July 1, 1997.
A method of RTP of a substrate where evaporation of the silicon is controlled is disclosed in US Patent 6,077,715, by Marcus et al. filed Jan. 29, 1998.
A method of producing silicon oxynitride films is disclosed in US Patent 6,303,520, by Kwong et al, filed on 12/15/98.
Methods of rotating the wafer in an RTP system are disclosed in USPatents 5,965,047 and 6,005,226 by Blersch et al. and Aschner et al. filed on 10/29/97 and 11/24/97 respectively, and in US Patent 6,449,428 by Aschner et al. filed on 12/11/98.

Further, attention is drawn to US-A-5,863,843 which shows a thermal processing apparatus and in particular a wafer holder for maintaining a semiconductor wafer at a constant temperature during film deposition. The thermal processing apparatus has a clear quartz shower head located above the wafer holder for distributing a reactive fluid over a surface of a wafer located on said wafer holder. Similar thermal processing apparatus are known from US-A-5,156,820 and from EP0847077.

### OBJECTS OF THE INVENTION

It is an object of the invention to produce a showerhead for supplying reactive fluids to the surface of an object being heated in an RTP system.
It is an object of the invention to produce a cooled showerhead for supplying reactive fluids to the surface of an object being heated in an RTP system.
It is an object of the invention to produce a showerhead for supplying reactive fluids to the surface of an object being heated in an RTP system such that the surface may also be irradiated by the radiation sources of the RTP system.
It is an object of the invention to produce a cooled showerhead for supplying reactive fluids to the surface of an object being heated in an RTP system wherein the cooling system for cooling the showerhead is inexpensive.
It is an object of the invention to produce a cooled showerhead for supplying reactive fluids to the surface of an object being heated in an RTP system whereby a plurality of gases may be supplied to the surface of the object, wherein the plurality of gases are first mixed in the space between the showerhead and the object.

In accordance with the present invention, an apparatus and a method for rapid thermal processing of an object as set fourth in claims 1 and 10, respectively are provided.

### SUMMARY OF THE INVENTION

An apparatus according to claim 1 and a method according to claim 10 are provided of a transparent showerhead for supplying reactive fluids to the surface of an object being heated in an RTP system. Innovative methods of cooling and mixing fluids are described. Interdigitated channels for supplying streams of fluid which exit through apertures in the channels are proposed. Counterpropagating interdigitated streams allow intermixing of reactive fluids in the space between the showerhead and the surface of the object being processed. A window of the RTP system and a showerhead are combined in an innovative way so that the cooling of the window and the showerhead may be combined to the same cooling apparatus.

### BRIEF DESCRIPTION OF THE DRAWINGS

Fig. 1 shows a sketch of an RTP system.
Fig. 2 shows a sketch of a means for distributing the flow of a reactive fluid.
Fig. shows an alternative embodiment of the invention.
Fig. 4 shows the most preferable embodiment of the invention.
Fig. 5 shows an alternative embodiment of the invention.
Fig. 6 shows an alternative embodiment of the
Fig. 7 shows a transparent plate 70 attached to a plurality of cooling half tubes 72.

### DETAILED DESCRIPTION OF THE INVENTION

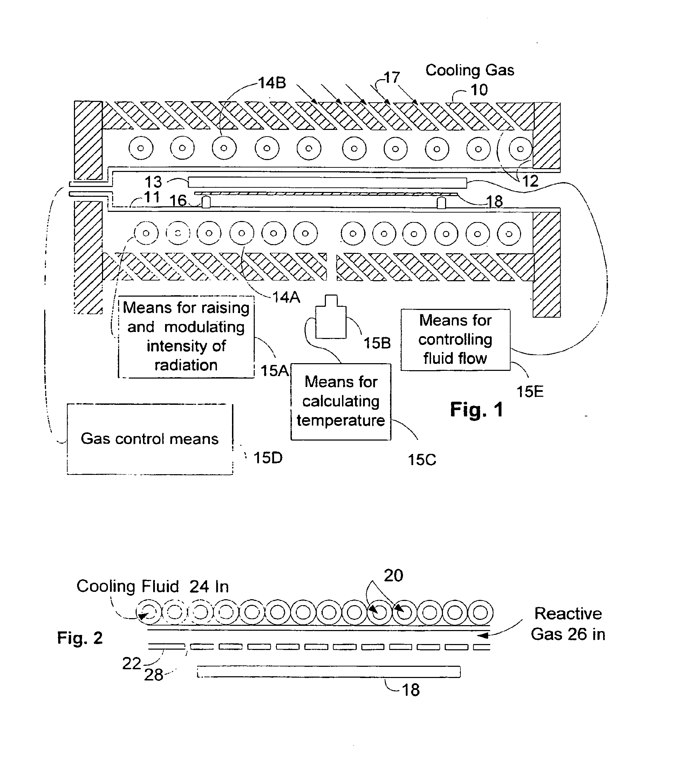

Figure 1 shows a sketch of an RTP system with an embodiment of the invention in place. A chamber 10 having reflecting walls 12 which reflect light from radiation sources 14A and 14B on to the object to be processed 18. The object 18 is generally a semiconductor wafer, but it may be any other material. The object is generally flat and round, but it may be flat and square or indeed any shape whatever. The object rests on pins 16. A chamber 11 surrounds the object so that the object may be processed in a process gas. While chamber 11 in early systems was a flat square box having one end open for introducing object 18, later chambers are flat round plates of quartz or sapphire with side walls of aluminum or stainless steel or other structural material. Openings fitted with doors for introducing object 18 into the reaction chamber are well known in the art. Means 15A for raising and modulating the intensity of radiation from the radiation sources 14A and 14B, means 15B for measuring the object temperature, means 15C for calculating temperature, means 15D for controlling the ambient gas surrounding the wafer, means 15E for controlling the flow of a fluid are shown, and are well known in the art. Means 15A-E may be stand alone pieces of apparatus each with their own microprocessor controllers, or may be controlled by a central computer system which is defined as being included in any of the means 15A-E, or may be any combination of embedded computer means or central computer menas. A means 13 for distributing a flow of reactive gases uniformly on to the surface of the wafer is shown schematically in fig. 1, and will be shown in much more detail and in various embodiments in later figures. A cooling gas 17 is shown being transported through the walls of chamber 10 for the purposes of cooling the chamber 10, the radiation sources 14A and 14B, and the walls of the chamber 11.

A preferred embodiment for the means 13 for distributing the flow of a reactive fluid on to the surface of the object 18 is shown in fig. 2. A grid of crossed tubes is presented, where one set of parallel tubes 20 carries a cooling fluid 24 to cool another set of parallel tubes 22. Cooling fluid 24 may be a gas such as air, nitrogen, argon, or other inert or reactive gas, or may be a liquid such as water or glycol or other common cooling fluid. The tubes 20 and 22 transmit the visible and/or near infrared light from the radiation sources 14B. A reactive gas 26 flows in tubes 22, and exits tubes 22 through apertures 28 to impinge uniformly onto a surface of object 18. Tubes 20 and 22 are preferably made from quartz but they may be made from any material transparent to the visible and near IR radiation from the lamps, and preferably joined at the places where the tubes are shown touching in fig. 2. The tubes 20 and 22 shown are round, but they may be replaced by tubes of square or other cross section. The quartz used may be the same type of quartz or other material used to make the chamber 11, or it may be a different type of quartz or another material , or it may indeed be made of any material which transmits a substantial proportion of the visible and/or near infra red (IR) light emitted from the radiation source 14B.

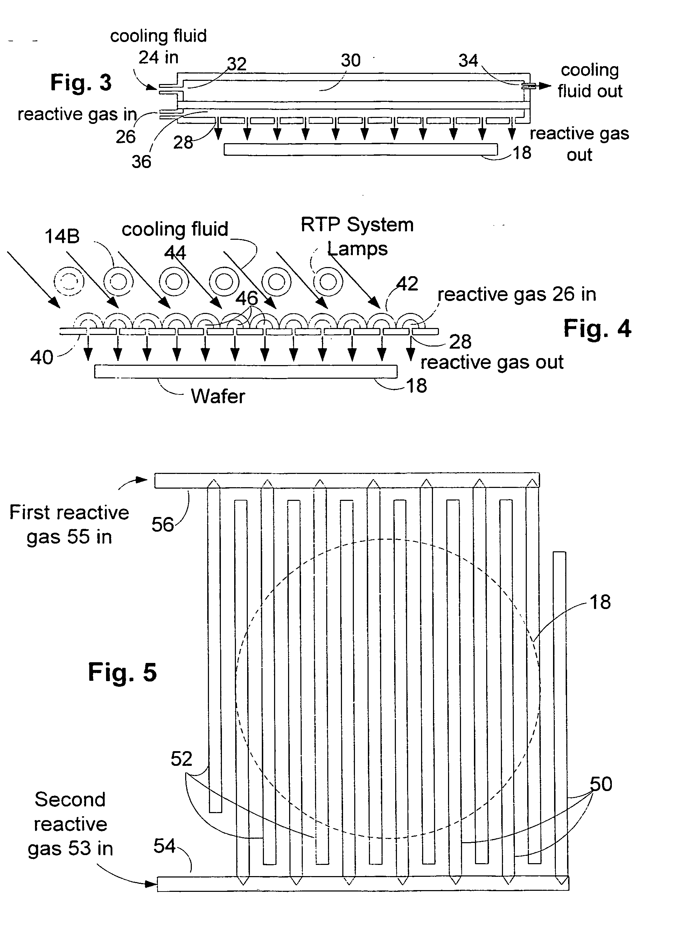

Fig. 3 shows an alternative embodiment of the invention, where the cross grid arrangement of figure 2 is replaced by a two chamber system formed by flat plates instead of tubes. A cooling fluid 24 enters a chamber 30 at 32 and flows along the chamber or in channels in the chamber and exits at 34. Chamber 30 shares a common wall with chamber 36. Reactive gas 26 enters chamber 36 and flows in chamber 36 or in channels in chamber 36 to apertures 28 in the exterior wall of chamber 36, where the reactive gas impinges uniformly on to a surface of object 18. The walls of chambers 30 and 36 are typically made of quartz, which may be the same or different quartz than the material of chamber 11, or they may indeed be made of any material which transmits a substantial proportion of the visible and/or near infra red (IR) light emitted from the radiation source 14B.

Fig. 4 shows the most preferable embodiment of the invention. One entire wall of the RTP chamber 11 is replaced by a quartz plate 40. A series of channels 46 are shown, in the case shown formed by a set of sawn in half tubes 42 joined to the quartz plate 40. A cooling fluid 44 cools the radiation sources 14B, and then impinges on and cools the tubes 42 and the plate 40. The plate 40 and tubes 42 can be used in place of the window normal used in an RTP system. The cooling system may be the cooling system normally used to cool the window and the lamps of an RTP system. The reactive gas 26 is introduced (not shown) into the channels 46 and exits apertures 28 to impinge uniformly on the object 18, which in this case is shown as a wafer. The cooling gas 44 cools the walls of the channels 46 and the reactive gas 26, so that the reactive gas 26 does not react and deposit on the interior walls of channels 46. The tubes 42 may have circular cross sections, as shown, or may have square, triangular, or other cross sections as necessary and as convenient for extrusion or other processes of forming such members.

Fig. 5 shows an alternative embodiment of the invention, wherein two pluralities of parallel channels like channels 46 are formed by two sets of tubes 50 and 52. A second reactive gas 53 enters the channels 50 from a tube 54, and a first reactive gas 55 enters channels 52 from tube 56. The interdigitated counterpropagating gas streams of gases 53 and 55 are introduced side by side through apertures (not shown) in the channels formed by tubes 50 and 52. In this way, the two reactive gases 53 and 55 do not mix at all until they are in the space between the body 13 and the object 18, which location is shown by the dotted circle in fig 4. This is very important if the two gases would react at low temperatures if they were mixed together. In fact, gases 53 and 55 may not both be reactive, as one could be an inert dilutant of for the other. The interdigitated channels sketched in fig. 5 may be used with the tubes of fig. 2, the chambers of fig 3 (with the addition of suitable channel walls (not shown) in the chamber 36 of fig. 3, or with the half tubes shown in fig. 4.

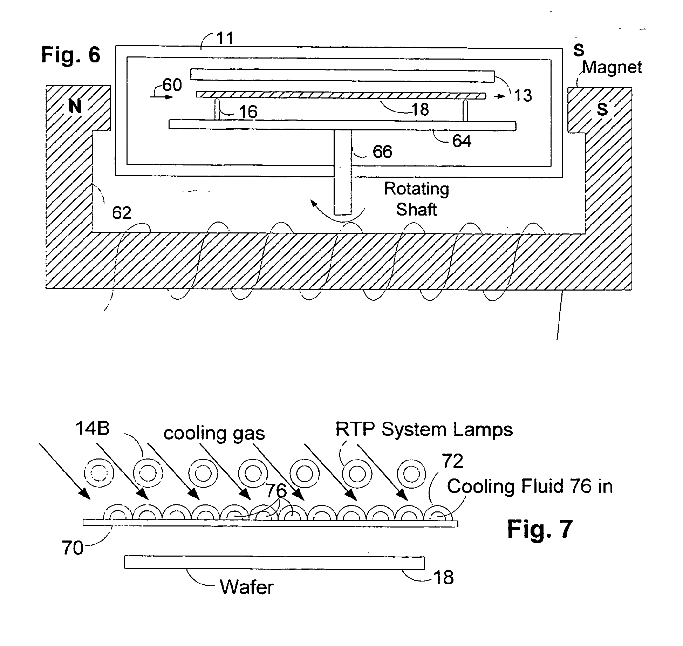

Fig. 6 shows an embodiment of the invention where the object to be processed 18 is immersed in a magnetic field 60 which is generated by a magnetic field generating means 62. The magnetic field is shown in fig. 6 to be parallel with the surface 64 of the object 18 where deposition is taking place, but the magnetic field could be perpendicular to the surface 64 or in any other direction as well. A succeptor 64 supported by a rotatable shaft 66 is shown to indicate that the object 18 may be rotated during deposition. A shaft is shown to indicate rotation means as are presently known in the art. Methods of rotating the wafer in an RTP system are disclosed in great detail in US Patent 5,965,047 and 6,005,226 by Blersch et al. and Aschner et al. filed on 10/29/97 and 11/24/97 respectively, and in US Patent 6,449,428 by Aschner et al.

In some applications it is quite difficult to get a uniform layer with a shower head, even if the shower head distributes the reactive gases very uniformly. This is due to the aerodynamic behavior of the gas influenced by e.g. the process chamber, the wafer or object, object holding means, guard rings or ring segments and so on. So rotating the object significantly improves the uniformity of the layers made on the surface of the wafer (or object to be processed).
The shower head may be used for chemical vapor deposition of a titanium nitride (TiN) layer on silicon. This layer is usually used as intermediate layer and diffusion barrier. In order to make the TiN layer, titanium tetrachloride (TiCl₄) and ammonia (NH₃) are used. Here it is important that the two gases have to be kept separate of each other, since they react even at room temperature with each other, resulting in solid NH₄Cl. So the shower head of the present invention is an ideal tool to keep the two gases separate in the gas handling system. In our invention, the gases are first mixed near by the surface of the wafer (a previous mixture is prevented), and the present invention even allows to adjust the ratio of the two gases in the process chamber. So the quality of the layer and the reaction rate can be controlled. The total reaction is 6 TiCl4 + 8 NH3 -> 6 TiN + 24 HCl + N2. Making such a layer of TiN by applying CVD and using a shower head is described in detail in "B. Froschle, Die Chemische Gasphasenabscheidung von Titannitrid durch Einwirkung thermischer Strahlung auf monokristalline Siliciumsubstrate zur Herstellung von Diffusionsbarrieren in der Mikroelektronik, Shaker Verlag, Aachen, 1997", which reference is included by reference in its entirety. In the above identified reference, a non transparent shower head was used and the wafer was heated from the bottom side only. The uniformity of the TiN layer (which is defined as ratio Dₘᵢₙ/Dₘₐₓ of the smallest and the largest thickness of the layer processed on a substrate) can be improved significantly by using the rotation option. For example without rotating the substrate Fröschle got a uniformity of 83% which is quite good for this difficult process. Using the shower head of the invention together with rotation of the wafer results in a much improved uniformity in the range of 94% and better. An additional advantage of the present invention is the possibility of dual side heating.
We have to note that the wafer cools down very much faster if the apparatus shown in figs. 1 to 5 is used. Instead of a reactive gas, the normal process gas or even an inert gas may be used for cooling. However, the present invention comprises an additionally embodiment for cooling the wafer or an object by applying similar channel systems as described above, wherein the channels are parts of a closed fluid transport system. Indeed, when a new apparatus as sketched in fig. 7 was used with no apertures, but only a flushed through cooling gas, the cool down time and thus the cycling time for the RTP apparatus was decreased.
Fig. 7 shows a transparent plate 70 attached to a plurality of cooling half tubes 72. Cooling fluid 76 is circulated in the cooling tubes. The cold wall 70 in close proximity to the surface of the wafer 18 absorbs the infra red radiation from the wafer 18 without reradiating the energy back to wafer 18. Clearly the stand alone bodies with interior channels sketched in figs. 2 and 3 may also be used for cooling purposes if they are built without apertures 28. A further interesting modification of the channel system of the shower head relates also to rapid cooling of the wafer. In the embodiment shown in fig. 7, the channel means have no connection to the inner space of the quartz chamber. This means that there are no apertures or nozzles 28 as shown in Fig 2. So the channel means are fully closed and a fluid (e.g. water or paraffin oil or a gas) can be circulated therein. During the heating process a first fluid is circulated in the channel means, and this first fluid has very little absorption of the visible and near IR radiation from the heating lamps. Such a first fluid could be for example nitrogen or dry air. If the temperature of the wafer must be ramped down very fast, the first fluid in the channel means is replaced by a second fluid (using suitable replacement means), and the second fluid absorbs the IR energy which is emitted by the wafer and the filaments of the lamps. Since the wafer and the filaments are emitting in a spectral range of 1 micrometer up to longer wavelengths, the second fluid should be opaque in this wavelength range. This scheme has the advantage that almost all energy which is emitted by the wafer is absorbed by the second fluid, and so from the quartz walls or other surfaces within the reactor there is nearly no energy emitted back to the wafer. The wafer cools almost as rapid as if it were in a free vacuum. Such a cooling is very interesting if the wafer has to be processed under vacuum conditions, and if no other cooling, e.g. with the previous shower heads, is possible.
Applying a magnetic field in RTP as shown in fig. 7 can be used for rapid thermal magnetic annealing of magnetic films. This offers the possibility to control solid state reactions (e.g. phase transitions) in a well defined way.
Example: Production of thin-film head devices for magnetic recording systems: To increase the bit density of magnetic storage media it is necessary to develop materials with high coercivity, to prevent demagnetization from neighboring bits with opposite sign, and to get a good thermal stability of the stored information.
Having such magnetic storage materials, special requirements for the magnetic material of the recording heads are necessary. Usually the material used for the recording heads is a so called soft magnetic material, having small coercivity and remanence parameters. Further the soft magnetic material should have a large saturation flux density, and for this reason the relative permeability has to be sufficiently high to create a magnetic field large enough to change the bit-information of the storage medium. A further requirement is that the permeability should also be sufficiently high at high frequencies, allowing fast read and write operations. An additional requirement is that the magnetostriction should be as low as possible, else unavoidable mechanical stress, occurring within the recording head, will lower the permeability.
To get high permeability even for the frequency range of 10 MHz it is necessary to build a crystalline ferromagnetic structure of small grains (or nanocrystalline structure). Further, usually it is advantageous if the orientation of the magnetic domain patterns have a predefined direction, depending on the application of the magnetic films or structures. This can be achieved by additionally applying a magnetic field during the process cycle of rapid thermal processing of the magnetic material. So the orientation of the magnetic domain patterns of the growing nanocrystals can be controlled. This can be done e.g. by applying an RTP-system with a controllable magnetic field, as described in connection with Fig. 6. One suitable soft magnetic material doing this is e.g. a FeNbSiN alloy. In this alloy two interesting phase transitions occur at about 350C and 530C. At 350C the formation of nanocrystalline Fe (in form of bcc structure - body-centered cubic Bravais lattice) happens, and at 530C fcc (face-centered cubic structure) NbN is formed.

The rate of formation of bcc Fe and the segregation of fcc NbN depends on the temperature according to Arrhenius' law. To get small grains of ferromagnetic material (in this case Fe), RTP offers the possibility to increase temperature between 350C and 530C very rapidly. At 530C segregation of NbN along the boundaries of the Fe-grains happens, and such the growth of the Fe-grains is stopped. The rate of formation of NbN also could be controlled by temperature due to Arrhenius' law. It is further important to cool the soft magnetic material very fast, preventing that too much segregation of NbN will occur. So with rapid heating and rapid cooling, RTP offers an ideal tool for creating soft magnetic materials for recording heads, having large permeability and extremely low magnetostriction. For comparison, with a conventional furnace annealing at 585C and 2h of processing time, the above mentioned alloy have a relative permeability in the range of 7000. With rapid thermal magnetic annealing permeabilities of 11000 are possible (e.g. 700C for 30s), and the magnetostriction value is approximately the same as in conventional furnace annealing. So RTP allows excellent control of phase transitions in magnetic structures due to fast ramp up and fast ramp down of the temperature. Obviously, many modifications and variations of the present invention are possible in light of the above teachings. It is therefore to be understood that, within the scope of the appended claims, the invention may be practiced otherwise then as specifically described.

## Claims

1. An apparatus for rapid thermal processing (RTP) of an object (18) in a RTP system, comprising:
first means (13, 22, 36, 40, 42 52) for transporting a first reactive fluid (26, 55) and distributing the first reactive fluid (26, 55) over a surface of the object (18), the first means (13, 22, 36, 52) transmitting visible and/or near infrared light from radiation sources (14B) of the RTP system, **characterized by**
second means (20, 30) for carrying a cooling fluid (24, 44) and transmitting visible and/or near infrared light, the second means (20, 30) being arranged with respect to the first means (13, 22, 36, 40, 42 52) for cooling the first reactive fluid (26, 55) until it exits the first means (13, 22, 36, 40, 42 52) and is directed onto the surface of the object (18).

2. The apparatus of claim 1, wherein the first means (13, 22, 36, 52) for transporting the first reactive fluid (26, 55) comprises a body in proximity to the surface of the object (18), the body having at least a first channel (22, 36, 52) for transporting the first reactive fluid (26, 55), the first channel having a large plurality of apertures (28) for distributing the first reactive fluid (26, 55) over the surface of the object (18).

3. The apparatus of claim 2, wherein the body comprises a plurality of interconnected tubes (50, 52).

4. The apparatus of claim 2, wherein the body has at least a second channel (20, 30), the second channel for transporting a cooling fluid (24) for cooling the body.

5. The apparatus of claim 4, wherein the body further comprises at least a third channel (50), the third channel for transporting a second reactive fluid (53) and distributing the second reactive fluid over the surface of the object (18), whereby the first (26, 55) and second (53) reactive fluids are first contacted in the space between the body and the object (18).

6. The apparatus of claim 5, wherein the first (22, 36, 52) and third (50) channels are part of an interdigitated system of channels for distributing the first (26, 55) and the second (53) reactive fluids.

7. The apparatus of claim 2, wherein RTP system comprises a chamber (10) for containing the object (18) to be processed and for containing process gas for processing the object, and wherein the body comprises a wall of the chamber (10).

8. The apparatus of claim 7, wherein the body is formed from different type of quartz used to make the chamber (10).

9. The apparatus of claim 1, further comprising a magnetic filed generating means (62).

10. A method for rapid thermal processing of an object (18), comprising:
transporting a first reactive fluid (26, 55) into a chamber of a RTP system and distributing the first reactive fluid over a surface of the object (18) using a first means (13, 22, 36, 40, 42, 52), the RTP system having a radiation source (14A, 14B) for illuminating the object (18) with radiation, the first means transmitting visible and/or near infrared light from the radiation sources (14B): **characterized by**
cooling the first reactive fluid (26, 55) with a cooling fluid (24, 44) carried by a second means (20, 30) until the first reactive fluid (26, 55) exits said first means (13, 22, 36, 40, 42, 52) and is directed onto the surface of the object (18) said second means (20, 30) being capable of transmitting visible and/or near infrared light,

11. The method of claim 10, wherein the first means (13, 22, 36, 52) for transporting the first reactive fluid (26, 55) comprises a body in proximity to the object (18), the body having at least a first channel (22, 36, 52) for transporting the first reactive fluid (26, 55), the first channel having a large plurality of apertures (28) for distributing the first reactive fluid (26, 55) uniformly over the surface of the object (18).

12. The method of claim 11, wherein the body comprises a plurality of interconnected tubes (52, 50).

13. The method of claim 11, wherein the body has at least a second channel (20, 30), the second channel for transporting a cooling fluid (24) for cooling the body.

14. The method of claim 13, wherein the body further comprises at least a third channel (50), the third channel for transporting a second reactive fluid (53) and distributing the second reactive fluid (53) over the surface of the object (18), whereby the first (26, 55) and second (53) reactive fluids are first contacted in the space between the body and the object (18).

15. The method of claim 14, wherein the first (22, 36, 52) and third (50) channels are part of an interdigitated system of channels for distributing the first (26, 55) and the second (53) reactive fluids.

16. The method of claim 10, further comprising generating a magnetic field (60) at a surface of the object (18).

## Patentansprüche

1. Vorrichtung zur raschen thermischen Behandlung (RTP = rapid thermal processing) eines Objekts 18 in einem RTP-System, die Folgendes aufweist:
erste Mittel (13, 22, 36, 40, 42, 52) zum Transportieren eines ersten reaktiven Fluids (26, 55) und zum Verteilen des ersten reaktiven Fluids (26, 55) über eine Oberfläche des Objekts 18, wobei die ersten Mittel (13, 22, 36, 52) sichtbares Licht und/oder Licht im nahen Infrarotbereich von Strahlungsquellen (14B) des RTP-Systems übertragen bzw. durchlassen, **gekennzeichnet durch**
zweite Mittel (20, 30) zum Führen eines Kühlfluids (24, 44) und zum Übertragen bzw. Durchlassen von sichtbaren Licht und/oder Licht im nahen Infrarotbereich, wobei die zweiten Mittel (20, 30) bezüglich der ersten Mittel (13, 22, 36, 40, 42, 52) angeordnet sind zum Kühlen des ersten reaktiven Fluids (26, 55) bis es aus den ersten Mitteln (13, 22, 36, 40, 42, 52) austritt und auf die Oberfläche des Objekts gerichtet wird.

2. Vorrichtung nach Anspruch 1, wobei die ersten Mittel (13, 22, 36, 52) zum Transportieren des ersten reaktiven Fluids (26, 55) einen Körper in Nähe zur Oberfläche des Objekts aufweisen, wobei der Körper wenigstens einen ersten Kanal (22, 36, 52) besitzt zum Transportieren des ersten reaktiven Fluids (26, 55) wobei der erste Kanal eine große Vielzahl von Öffnungen (28) aufweist zum Verteilen des ersten reaktiven Fluids (26, 55) über die Oberfläche des Objekts (18).

3. Vorrichtung nach Anspruch 2, wobei der Körper eine Vielzahl von miteinander verbundenen Rohren (50, 52) aufweist.

4. Vorrichtung nach Anspruch 2, wobei der Körper wenigstens einen zweiten Kanal (20, 30) aufweist, wobei der zweite Kanal zum Transportieren eines Kühlfluids (24) zum Kühlen des Körpers vorgesehen ist.

5. Vorrichtung nach Anspruch 4, wobei der Körper ferner wenigstens einen dritten Kanal (50) aufweist, wobei der dritte Kanal zum Transportieren eines zweiten reaktiven Fluids (53) und zum Verteilen des zweiten reaktiven Fluids über die Oberfläche des Objekts (18) vorgesehen ist, wodurch das erste (26, 55) und das zweite (53) reaktive Fluid sich erst in dem Raum zwischen dem Körper und dem Objekt (18) kontaktieren.

6. Vorrichtung nach Anspruch 5, wobei die ersten (22, 36, 52) und dritten (50) Kanäle teil eines ineinander greifenden Systems von Kanälen sind zum Verteilen der ersten (26, 55) und zweiten (53) reaktiven Fluids.

7. Vorrichtung nach Anspruch 2, wobei das RTP-System ferner eine Kammer (10) zum Halten des zu behandelnden Objekts (18) und zum Halten von Prozessgas zum Behandeln des Objekts aufweist, und wobei der Körper eine Wand der Kammer (10) aufweist.

8. Vorrichtung nach Anspruch 7, wobei der Körper aus einem unterschiedlichen Typ Quarz gebildet ist, als dem Quarz der zur Bildung der Kammer (10) verwendet wird.

9. Vorrichtung nach Anspruch 1, die ferner Magnetfelderzeugungsmittel (62) aufweist.

10. Verfahren zur raschen thermischen Behandlung eines Objekts (18), das die Folgenden Schritte aufweist:
Transportieren eines ersten reaktiven Fluids (26, 55) in eine Kammer eines RTP-Systems und Verteilen des ersten reaktiven Fluids über eine Oberfläche des Objekts (18) unter Verwendung erster Mittel (13, 22, 36, 40, 42, 52), wobei das RTP-System eine Strahlungsquelle (14A, 14B) aufweist zum Beleuchten des Objekts (18) mit Strahlung, wobei die ersten Mittel sichtbares Licht und/oder Licht im nahen Infrarotbereich von den Strahlungsquellen (14B) übertragen; **gekennzeichnet durch**
Kühlen des ersten reaktiven Fluids (26, 55) mit einem Kühlfluid (24, 44), das **durch** zweite Mittel (20, 30) geführt wird, bis das erste reaktive Fluid (26, 55) aus den ersten Mitteln (13, 22, 36, 40, 42, 52) austritt und auf die Oberfläche des Objekts (18) gerichtet wird, wobei die zweiten Mittel (20, 30) in der Lage sind sichtbares Licht und/oder Licht im nahen Infrarotbereich zu übertragen.

11. Verfahren nach Anspruch 10, wobei die ersten Mittel (13, 22, 36, 52) zum Transportieren des ersten reaktiven Fluids (26, 55) einen Körper in der Nähe des Objekts (18) aufweisen, wobei der Körper wenigstens einen ersten Kanal (22, 36, 52) aufweist zum Transportieren des ersten reaktiven Fluids (26, 55), wobei der erste Kanal eine große Vielzahl von Öffnungen (28) aufweist zum Verteilen des ersten reaktiven Fluids (26, 55) gleichförmig über die Oberfläche des Objekts (18).

12. Verfahren nach Anspruch 11, wobei der Körper eine Vielzahl von miteinander verbundenen Rohren (52, 50) aufweist.

13. Verfahren nach Anspruch 11, wobei der Körper wenigstens einen zweiten Kanal (20, 30) aufweist, wobei der zweite Kanal zum Transportieren eines Kühlfluids (24) zum Kühlen des Körpers vorgesehen ist.

14. Verfahren nach Anspruch 13, wobei der Körper ferner wenigstens einen dritten Kanal (50) aufweist, wobei der dritte Kanal zum Transportieren eines zweiten reaktiven Fluids (53) und zum Verteilen des zweiten reaktiven Fluids (53) über die Oberfläche des Objekts (18) vorgesehen ist, wodurch sich die ersten (26, 55) und zweiten (53) reaktiven Fluids erstmals in dem Raum zwischen dem Körper und dem Objekt (18) kontaktieren.

15. Verfahren nach Anspruch 14, wobei die ersten (22, 36, 52) und dritten (50) Kanäle wenigstens teilweise ein ineinander greifendes System von Kanälen bildet zum Verteilen der ersten (26, 55) und der zweiten (53) reaktiven Fluids.

16. Verfahren nach Anspruch 10, das ferner das Erzeugen eines Magnetfeldes (26) an einer Oberfläche des Objekts (18) aufweist.

## Revendications

1. Dispositif pour le traitement thermique rapide (RTP) d'un objet (18) dans un système RTP, comprenant :
des premiers moyens (13, 22, 36, 40, 42, 52) pour transporter un premier fluide réactif (26, 55) et répartir le premier fluide réactif (26, 55) sur une surface de l'objet (18), les premiers moyens (13, 22, 36, 52) émettant de la lumière visible et/ou dans le proche infrarouge à partir de sources de rayonnement (14B) du système RTP ;
**caractérisé par** :
des deuxièmes moyens (20, 30) pour transporter un fluide de refroidissement (24, 44) et émettre de la lumière visible et/ou dans le proche infrarouge, les deuxièmes moyens (20, 30) étant disposés par rapport aux premiers moyens (13, 22, 36, 40, 42, 52) pour refroidir le premier fluide réactif (26, 55) jusqu'à ce qu'il sorte des premiers moyens (13, 22, 36, 40, 42, 52) et qu'il soit dirigé vers la surface de l'objet (18).

2. Dispositif selon la revendication 1, dans lequel les premiers moyens (13, 22, 36, 52) pour transporter le premier fluide réactif (26, 55) comprennent un corps à proximité de la surface de l'objet (18), le corps comportant au moins un premier canal (22, 36, 52) pour transporter le premier fluide réactif (26, 55), le premier canal comportant une grande quantité d'ouvertures (28) pour répartir le premier fluide réactif (26, 55) sur la surface de l'objet (18).

3. Dispositif selon la revendication 2, dans lequel le corps comprend une pluralité de tubes interconnectés (50, 52).

4. Dispositif selon la revendication 2, dans lequel le corps comprend au moins un deuxième canal (20, 30), le deuxième canal étant destiné à transporter un fluide de refroidissement (24) pour refroidir le corps.

5. Dispositif selon la revendication 4, dans lequel le corps comprend en outre au moins un troisième canal (50), le troisième canal étant destiné à transporter un deuxième fluide (53) et à répartir le deuxième fluide réactif sur la surface de l'objet (18), d'où il résulte que les premier (26, 55) et deuxième (53) fluides réactifs sont d'abord mis en contact dans l'espace situé entre le corps et l'objet (18).

6. Dispositif selon la revendication 5, dans lequel les premier (22, 36, 52) et troisième (50) canaux font partie d'un système interdigité de canaux pour répartir les premier (26, 55) et deuxième (53) fluides réactifs.

7. Dispositif selon la revendication 2, dans lequel le système RTP comprend une chambre (10) pour contenir l'objet (18) à traiter et pour contenir un gaz de traitement pour traiter l'objet, et dans lequel le corps comprend une paroi de la chambre (10).

8. Dispositif selon la revendication 7, dans lequel le corps est formé en un type de quartz différent de celui utilisé pour fabriquer la chambre (10).

9. Dispositif selon la revendication 1, comprenant en outre un moyen de génération de champ magnétique (62).

10. Procédé pour le traitement thermique rapide d'un objet (18), comprenant l'étape suivante :
transporter un premier fluide réactif (26, 55) dans une chambre d'un système RTP et répartir le premier fluide réactif sur une surface de l'objet (18) en utilisant des premiers moyens (13, 22, 36, 40, 42, 52), le système RTP comportant une source de rayonnement (14A, 14B) pour éclairer l'objet (18) avec le rayonnement, les premiers moyens émettant de la lumière visible et/ou dans le proche infrarouge à partir des sources de rayonnement (14B) ;
**caractérisé par** l'étape suivante :
refroidir le premier fluide réactif (26, 55) avec un fluide de refroidissement (24, 44) transporté par des deuxièmes moyens (20, 30) jusqu'à ce que le premier fluide réactif (26, 55) sorte des premiers moyens (13, 22, 36, 40, 42, 52) et qu'il soit dirigé sur la surface de l'objet (18), les deuxièmes moyens (20, 30) étant capables d'émettre de la lumière visible et/ou dans le proche infrarouge.

11. Procédé selon la revendication 10, dans lequel les premiers moyens (13, 22, 36, 52) pour transporter le premier fluide réactif (26, 55) comprennent un corps à proximité de l'objet (18), le corps comportant au moins un premier canal (22, 36, 52) pour transporter le premier fluide réactif (26, 55), le premier canal comportant une grande quantité d'ouvertures (28) pour répartir le premier fluide réactif (26, 55) uniformément sur la surface de l'objet (18).

12. Procédé selon la revendication 11, dans lequel le corps comprend une pluralité de tubes interconnectés (52, 50).

13. Procédé selon la revendication 11, dans lequel le corps comporte au moins un deuxième canal (20, 30), le deuxième canal étant destiné à transporter un fluide de refroidissement (24) pour refroidir le corps.

14. Procédé selon la revendication 13, dans lequel le corps comprend en outre au moins un troisième canal (50), le troisième canal étant destiné à transporter un deuxième fluide réactif (53) et à répartir le deuxième fluide réactif (53) sur la surface de l'objet (18), d'où il résulte que les premier (26, 55) et deuxième (53) fluides réactifs sont d'abord mis en contact dans l'espace situé entre le corps et l'objet (18).

15. Procédé selon la revendication 14, dans lequel les premier (22, 36, 52) et troisième (50) canaux font partie d'un système interdigité de canaux pour répartir les premier (26, 55) et deuxième (53) fluides réactifs.

16. Procédé selon la revendication 10, comprenant en outre la génération d'un champ magnétique (60) au niveau d'une surface de l'objet (18).
